(19) Europäisches Patentamt / European Patent Office / Office européen des brevets

(11) **EP 3 099 610 B1**

## (12) EUROPEAN PATENT SPECIFICATION

(45) Date of publication and mention
of the grant of the patent:
**30.03.2022 Bulletin 2022/13**

(21) Application number: **15743184.2**

(22) Date of filing: **01.02.2015**

(51) International Patent Classification (IPC):
**B06B 1/02** (2006.01)    **B06B 3/00** (2006.01)
**F16C 32/06** (2006.01)    **H01L 21/677** (2006.01)
**H01L 21/683** (2006.01)   **B06B 1/06** (2006.01)

(52) Cooperative Patent Classification (CPC):
**B06B 1/06; B06B 1/0223; B06B 3/00;
F16C 32/0611; H01L 21/67784; H01L 21/67787;
H01L 21/6838**

(86) International application number:
**PCT/IL2015/050110**

(87) International publication number:
**WO 2015/114634 (06.08.2015 Gazette 2015/31)**

## (54) METHOD AND SYSTEM FOR NON-CONTACT LEVITATION

VERFAHREN UND SYSTEM FÜR KONTAKTLOSE SCHWEBETECHNIK

PROCÉDÉ ET SYSTÈME DE LÉVITATION SANS CONTACT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.02.2014 US 201461934774 P**

(43) Date of publication of application:
**07.12.2016 Bulletin 2016/49**

(73) Proprietor: **Technion Research & Development
Foundation Ltd.
3200004 Haifa (IL)**

(72) Inventor: **BUCHER, Izhak
3448708 Haifa (IL)**

(74) Representative: **Forresters IP LLP
Skygarden
Erika-Mann-Straße 11
80636 München (DE)**

(56) References cited:
**US-A- 5 810 155      US-A1- 2002 088 280
US-A1- 2002 088 280**

• A. MINIKES ET AL: "Coupled dynamics of a squeeze-film levitated mass and a vibrating piezoelectric disc: numerical analysis and experimental study", JOURNAL OF SOUND AND VIBRATION, vol. 263, no. 2, 1 May 2003 (2003-05-01), pages 241-268, XP55216679, ISSN: 0022-460X, DOI: 10.1016/S0022-460X(02)01121-5
• LI JIN ET AL: "Nonlinear restoring forces and geometry influence on stability in near-field acoustic levitation", JOURNAL OF APPLIED PHYSICS, AMERICAN INSTITUTE OF PHYSICS, US, vol. 109, no. 8, 22 April 2011 (2011-04-22), pages 84518-84518, XP012148949, ISSN: 0021-8979, DOI: 10.1063/1.3575179
• VANDAELE V ET AL: "Non-contact handling in microassembly: Acoustical levitation", PRECISION ENGINEERING, ELSEVIER, AMSTERDAM, NL, vol. 29, no. 4, 1 October 2005 (2005-10-01), pages 491-505, XP027766700, ISSN: 0141-6359 [retrieved on 2005-10-01]
• LI, JIN ET AL.: 'Nonlinear restoring forces and geometry influence on stability in near-field acoustic levitation' JOURNAL OF APPLIED PHYSICS, [Online] vol. 109, no. ISSUE, 2011, page 084518, XP012148949 Retrieved from the Internet: <URL:http://www.math.psu.edu/cao/Papers_PDF/LiJin 4-22-2011 .pdf>

EP 3 099 610 B1

- **MINIKES, ADI ET AL.: 'Coupled dynamics of a squeeze-film levitated mass and a vibrating piezoelectric disc: numerical analysis and experimental study' JOURNAL OF SOUND AND VIBRATION, [Online] vol. 263, no. ISSUE, 2003, pages 241 - 268, XP055216679 Retrieved from the Internet: <URL:http://www.researchgate.net/ profile/Izhak_Bucher/publication/243366104_ Coupled_dynamics_of_a squeeze-film_levitated_mass_and_a_vibrating_piezoel ectric_disc_numerical_analysis_and_experime nt al_study/links/00b4952159dfb8a653000000.pdf >**

**Description**

FIELD AND BACKGROUND OF THE INVENTION

The present invention, in some embodiments thereof, relates to non-contact levitation and, more particularly, but not exclusively, to a method and system for acoustic levitation.

Known levitation techniques are based on acoustic pressure, electrostatic forces, electrodynamic forces, magnetic forces, optical pressure and aerodynamics. Of these techniques, acoustic levitation is known to be applicable to any material in any gaseous or liquid medium. Acoustic levitation systems are well known for levitation of objects by using standing acoustic pressure waves between an emitter generating these waves and a reflector. Typically, a standing acoustic wave pattern is developed with a length of half of its wavelength between a usually planar emitter surface and a concave reflector with a preferentially spherical surface section providing significantly higher levitation forces compared to flat reflector surfaces.

The principles of acoustic levitation are well established. Sound exerts a small but continuous force on materials in a sound field over and above the pressure oscillation occurring at that frequency. Various acoustic levitation systems have been devised whereby continuous forces exerted by the acoustic standing wave are enhanced sufficiently to enable small objects to be suspended in a sound field without visible means of support.

Document entitled "Coupled dynamics of a squeeze-film levitated mass and a vibrating piezoelectric disc: numerical analysis and experimental study" (from A. Minikes et al., Journal of Sound and Vibration, Vol. 263, n°2, pp. 241-268, 01/05/2003) discloses a levitation system using a piezoelectric actuator coupled to a resonating supportive member.

Acoustic levitation using tuned chambers are described in U.S. Patent Nos. 3,882,732, 4,520,656 and 4,054,181. Acoustic levitation in which a sound wave is directed toward a reflector is described in U.S. Patent Nos. 4,284,403 and 4,777,823. U.S. Patent No. 5,036,944 describes a method and apparatus for acoustic levitation in which an object is suspended between pairs of opposed sound sources driven at the same frequency.

U.S. Patent No. 5,810,155 describes a typical near-field levitation system, which allows transport of planar objects by applying further acoustic waves using ultrasonic radiators, or through inclining the whole levitator system so that gravity forces does no longer appear perpendicular to the objects. In U.S. Patent No. 6,575,669, a near-field levitator with a number of transporting vibrators is disclosed, wherein the transporting vibrators are inclined to each other for transporting objects.

SUMMARY OF THE INVENTION

According to an aspect of some embodiments of the present invention there is provided a levitation system. The system comprises: at least one levitation device having a plurality of vibration actuators, and a band structure, shaped as a loop and being coupled to the vibration actuators. The system also comprises a controller configured to synchronize vibrations of the vibration actuators to generate in the band structure traveling mechanical waves. The controller has an electronic circuit and a non-volatile memory medium readable by the circuit, wherein the memory medium stores program instructions which, when read by the circuit, cause the circuit to synchronize vibrations of the vibration actuators to generate in the band structure traveling mechanical waves.

According to some embodiments of the invention the traveling mechanical waves are at amplitude which is within a resonance bandwidth corresponding to at least one normal mode of the band structure.

According to some embodiments of the invention the loop is a vertical loop. According to some embodiments of the invention the loop is a horizontal loop.

According to some embodiments of the invention the at least one levitation device comprises a plurality of levitation devices arranged on a supportive surface.

According to some embodiments of the invention the program instructions cause the circuit to synchronize vibrations of actuators of respective levitation devices to manipulate an object levitated above the levitation devices in six degrees of freedom.

According to some embodiments of the invention the plurality of levitation devices is arranged at equal distances from a point on the supportive surface.

According to some embodiments of the invention the system further comprises at least one additional levitation device having a flexible tapered member physically coupled to a vibration actuator via a flexible rod, wherein a widest surface of the tapered member is responsive to a vibration of the actuator by exhibiting a three-dimensional deformation.

According to some embodiments of the invention the system further comprises a plurality of additional levitation devices, each additional levitation device having a flexible tapered member physically coupled to a vibration actuator via a flexible rod, wherein a widest surface of the tapered member is responsive to a vibration of the actuator by exhibiting a three-dimensional deformation. According to some embodiments of the invention the program instructions cause the circuit to synchronize vibrations of actuators of respective levitation devices and respective additional levitation devices to manipulate an object levitated above the levitation devices in six degrees of freedom.

According to some embodiments of the invention the system further comprises a sensing system, wherein the program instructions cause the circuit to receive from the sensing system data pertaining to orientation, tilt and/or position of the object and to synchronize the vibrations responsively to the data.

According to an aspect of some embodiments of the present invention there is provided a method of levitating an object. The method comprises placing the object on a levitation system having at least one levitation device, and activating the at least one levitation device. In various exemplary embodiments of the invention the levitation system comprises the system as delineated above and optionally as further detailed below.

According to some embodiments of the invention the object is a semiconductor chip or a semiconductor wafer.

According to an aspect of some embodiments of the present invention there is provided a method of levitating an object. The method comprises: placing the object on a surface of levitation system so as to levitate the object above the surface; horizontally accelerating the surface; and simultaneously with the horizontal acceleration, tilting the surface at an angle that equals an inclination angle of a vector sum of a gravitational acceleration and the horizontal acceleration.

Unless otherwise defined, all technical and/or scientific terms used herein have the same meaning as commonly understood by one of ordinary skill in the art to which the invention pertains. Although methods and materials similar or equivalent to those described herein can be used in the practice or testing of embodiments of the invention, exemplary methods and/or materials are described below. The invention is defined by the appended claims.

Implementation of the method and/or system of embodiments of the invention can involve performing or completing selected tasks manually, automatically, or a combination thereof. Moreover, according to actual instrumentation and equipment of embodiments of the method and/or system of the invention, several selected tasks could be implemented by hardware, by software or by firmware or by a combination thereof using an operating system.

For example, hardware for performing selected tasks according to embodiments of the invention could be implemented as a chip or a circuit. As software, selected tasks according to embodiments of the invention could be implemented as a plurality of software instructions being executed by a computer using any suitable operating system. In an exemplary embodiment of the invention, one or more tasks according to exemplary embodiments of method and/or system as described herein are performed by a data processor, such as a computing platform for executing a plurality of instructions. Optionally, the data processor includes a volatile memory for storing instructions and/or data and/or a non-volatile storage, for example, a magnetic hard-disk and/or removable media, for storing instructions and/or data. Optionally, a network connection is provided as well. A display and/or a user input device such as a keyboard or mouse are optionally provided as well.

BRIEF DESCRIPTION OF THE DRAWINGS

Some embodiments of the invention are herein described, by way of example only, with reference to the accompanying drawings and images. With specific reference now to the drawings in detail, it is stressed that the particulars shown are by way of example and for purposes of illustrative discussion of embodiments of the invention. In this regard, the description taken with the drawings makes apparent to those skilled in the art how embodiments of the invention may be practiced.

In the drawings:

FIG. 1 is a schematic illustration of a levitation device;

FIG. 2 is an illustration of deformed shapes of the widest surface of a tapered member of the device shown in FIG. 1;

FIGs. 3A-C are schematic illustrations of a levitation system, in examples in which the system comprises a plurality of levitation devices;

FIGs. 4A-B are schematic illustrations of a levitation system, in embodiments of the invention in which levitation is effected by traveling waves;

FIGs. 5A-B show two normal modes of a band structure, in embodiments of the invention in which the structure forms a vertical loop;

FIGs. 6A-B show two normal modes of a band structure, in embodiments of the invention in which the structure forms a horizontal loop;

FIGs. 7A-B are schematic illustrations of top views of a levitation system in embodiments of the invention in which the system comprises more than one levitation device that generates traveling waves;

FIG. 8 is a schematic illustration of a clockwise rotation of an object about a vertical axis by generating traveling waves in band structures of three levitation devices;

FIGs. 9A-B are schematic illustrations of top views of a levitation system in embodiments of the invention in which the system comprises several levitation devices that generate traveling waves, and the levitation device of FIG. 1;

FIGs. 10A-B are schematic illustrations of top views of a levitation system in embodiments of the invention in which the system comprises several levitation devices that generate traveling waves, and several levitation devices as in FIG. 1;

FIGs. 11A-B are schematic illustrations of a system that accelerates a levitated object;

FIGs. 12A-C show a simplified relationship between volume and pressure, as calculated according to some embodiments of the present invention;

FIG. 13 is a schematic illustration of axial elongation, demonstrating mechanical amplification employable by a levitation device according to some embodiments of the present invention;

FIG. 14 shows displacement in $\mu$m as a function of the time, as obtained during experiments performed according to some embodiments of the present invention;

FIG. 15A is a schematic illustration of kinematics of points on a surface;

FIG. 15B illustrates numerical simulation results of a wave generated in a band structure; and

FIGs. 16A-B are images of a prototype system including four levitation devices and an upper plate according to some embodiments of the present invention.

DESCRIPTION OF SPECIFIC EMBODIMENTS OF THE INVENTION

The present invention, in some embodiments thereof, relates to non-contact levitation and, more particularly, but not exclusively, to a method and system for acoustic levitation.

Before explaining at least one embodiment of the invention in detail, it is to be understood that the invention is not necessarily limited in its application to the details of construction and the arrangement of the components and/or methods set forth in the following description and/or illustrated in the drawings and/or the Examples. The invention is capable of other embodiments or of being practiced or carried out in various ways, as long as said ways stay in the scope of the invention which is defined by the appended claims.

Some embodiments of the present invention comprise a levitation system and method that can effect levitation of an object when placed above the levitation system. The present inventors have devised a configuration that allows efficient levitation of macroscopic objects, typically at the centimeter scale (e.g., from about 1 cm to about 80 cm in diameter). For example, the system and method of the present embodiments can be used to levitate a semiconductor chip, particularly a flexible semiconductor chip, such as, but not limited to, a silicon wafer.

The system and method according to some embodiments of the present invention allows the manipulation of the levitated object without contaminating it through physical contact with any hard surface. These embodiments are useful, particularly, but not exclusively, in clean rooms, where it is desired to avoid mechanical contact as it causes contamination and destroys the components of the manufactured devices. The system and method of the present embodiments allow the manipulation of object at a substantially reduced friction. The medium between the levitated object and the system of the present embodiments is gaseous (typically air). Such a medium contributes to a cushioning effect, damping the vibration of the system.

The levitation effected by the technique of the present embodiments optionally and preferably consumes relatively small amount of electrical power. For example, it was demonstrated by the present inventor that a silicon wafer at the centimeter scale can be levitated above the levitation system using electrical power of a few watts.

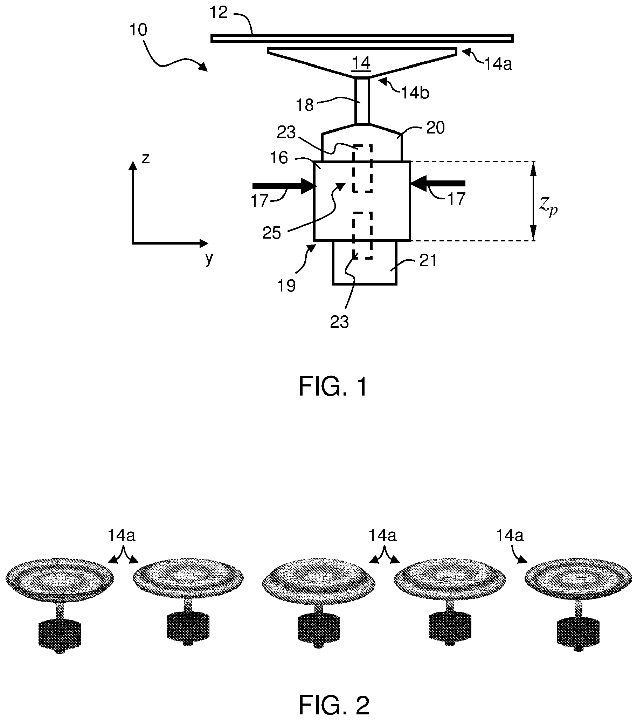

Referring now to the drawings, FIG. 1 is a schematic illustration of a levitation device 10 not embodying the present invention. A levitation system as disclosed herein can include one or more levitation devices such as device 10 as further detailed hereinbelow.

Device 10 can be used to effect levitation of an object 12. The levitation is preferably non-contact levitation by means of a near field pressure generated by device 10. Optionally and preferably, the pressure field is generated at sonic or ultrasonic frequencies. Object 12 can be a generally flat object, such as, but not limited to, a wafer. Object 12 can be rigid or flexible. The size of object 12 can be at the centimeter scale, e.g., from about 1 cm to about 80 cm, or from about 10 cm to about 80 cm, or from about 20 cm to about 50 cm, or from about 25 cm to about 50 cm. The thickness of object 12 is typically, from about 0.1 mm to about 10 mm. The weight of object 12 is typically less than a few hundreds of grams, e.g., from about 1 gram to about 300 grams or from about 20 grams to about 300 grams, or from about 100 grams to about 300 grams. In some examples object 12 is a silicon wafer, about 300 mm in diameter and about 275 $\mu$m in thickness, or about 450 mm in diameter and about 825 $\mu$m in thickness. Other sizes, weights and types of objects are also contemplated.

In various examples device 10 comprises a horizontal tapered member 14, which is physically coupled to a vibration actuator 16 via a vertical rod 18.

Herein, "vertical" refers to a direction generally parallel (e.g., with deviation of less than 5°) to the direction of the Earth's gravitational field, and "horizontal" refers to a direction generally perpendicular (e.g., within the range 90+5°) to the vertical direction.

The vertical direction is shown as the z-axis in FIG. 1. The y axis represents a horizontal direction. Another horizontal direction can be the x-axis, which is not shown in FIG. 1 but should be understood as perpendicular to the y-z plane. A plane at or parallel to the x-y plane is referred to below as a horizontal plane. Device 10 can also be described using a cylindrical coordinate system. In this coordinate system the vertical direction is also referred to herein the z-axis, and the horizontal directions can be the radial and the azimuthal directions, where the radial direction points away from, and perpendicularly to, the vertical direction, and the azimuthal direction is perpendicular to the radial and the vertical directions, as known in the art. Rod 18 is preferably axially flexible. Typically, but not exclusively, rod 18 is made of a material that sustains elongation of from about 0.1 $\mu$m to about 10 $\mu$m without break, with relative elongation ΔL/L of at least 0.005% or at least 0.01%, for example, from about 0.005% to about 0.1% or from about 0.01% to about 0.1%.

Tapered member 14 has a wide end 14a and a narrow end 14b, wherein rod 18 is connected to, or forms an integral part of, the narrow end 14b. In various examples the upper surface at 14a is generally flat. Tapered member 14 optionally and preferably has the shape of a frustum, such as, but not limited to, a conical frustum (e.g., circular, elliptic), or a pyramidal frustum. The diameter of the widest surface of member 14 (the surface at end 14a) is preferably from about 10 mm to about 300 mm, or from about 10 mm to about 200 mm or from about 10 mm to about 100 mm. Other diameters are also contemplated.

Tapered member 14 is preferably flexible. In various examples the material and size of tapered member 14 are selected such that tapered member 14 can sustains elongation at an extent which is at least the same as the elongation of rod 18.

In some examples rod 18 and member 14 form a monolithic structure made of the same material.

Preferably, rod 18 and member 14 (whether provided separately or as a monolithic structure) are made of a material capable of developing high strain without plastic deformations or internal energy loss leading to significant hysteresis. Representative examples of materials suitable for rod 18 and member 14 include, without limitation, metal or metal alloy, e.g., steel, aluminum, magnesium super-alloy, or any combination thereof.

Vibration actuator 16 can be of any type capable of generating mechanical vibrations in rod 18. For example, actuator 16 can comprise a piezoelectric crystal. In some examples actuator 16 is a Langevin actuator.

The vibration frequency of actuator 16 is preferably sonic or ultrasonic. Suitable frequency range for actuator 16 including, without limitation, from about 0.5 kHz to about 1 MHz, or from about 1 kHz to about 1 MHz, or from about 1 kHz to about 100 kHz or from about 1 kHz to about 50 kHz.

The vibration of actuator 16 is transmitted by rod 18, generally along the vertical direction to tapered member 14. Tapered member 14 is responsive to these vibrations by exhibiting a three-dimensional deformation at least at the widest surface at end 14a. The deformation is three-dimensional since it occurs along three orthogonal axes. For example, responsive to the vibration, the widest surface becomes non-planar, so that there are at least two material points over the surface between which the inter-distance along the vertical direction varies, at least two material points over the surface between which the inter-distance along the radial direction varies, and at least two material points over the surface between which the inter-distance along the azimuthal direction varies. Representative example of deformed shapes of the widest surface of end 14a, at several time instances during a single vibration cycle of actuator 16 are illustrated in FIG. 2.

In various examples the three-dimensional deformation of member 14 is devoid of nodal lines. Preferably, the three-dimensional deformation has a small number of nodal circles. Typically, there are less than 3 nodal circles in total.

It was found by the present Inventor that the common approach whereby a quarter wavelength horn amplifier is appended with a disk is far from optimal, since the acoustic levitation depends on the developed pressure times the area of end 14a. Thus, according to some examples the various vibrating elements of device 10 are designed by considering is considered them as unison, with the end goal being the levitation performance. Device 10 is optionally and preferably designed to obtain large flapping of member 14 by exchanging the kinetic energy of member 14 with the strain energy contained in rod 18 and optionally other elements of device 10. The tapering of member 14, increases its natural frequencies so that the axisymmetric frequencies have a smaller number of nodal circles coincides with the selected frequency of excitation. This is optionally and preferably performed by solving, using a data processor, an optimization problem with one, or more preferably a plurality of constraints. Representative of constraints include, without limitation, the frequency of actuator 16, minimal number of nodal circles, and maximal amplification of the vibration of member 14 for unit displacement of actuator 16.

In some examples device 10 comprises a rigid member 20, between rod 18 and actuator 16. Rigid member 20 can be connected to rod 18 or it can form a monolithic structure therewith. In various examples rigid member 20, rod 18 and tapered member 14 form together a monolithic structure. Rigid member 20 serves for supporting rod 18 and for providing mass to device 10 so as to enhance the coupling between actuator 16 and rod 18, therefore also to reduce loss of energy during the transmission of vibration.

In some examples device 10 comprises an additional rigid member 21 mounted such that actuator 16 is between rigid members 20 and 21. The mass of member 21 is selected to ensure that the location of the axial nodal point of actuator 16 is at a predetermined vertical location, generally shown by arrows 17. The vertical location 17 is optionally and preferably above the vertical center of actuator 16. Denoting the vertical height of actuator 16 by $z_p$ vertical location 17 is preferably at a distance of more than $0.5z_p$ e.g., at least $0.6z_p$ or at least $0.7z_p$ or at least $0.8z_p$ or at least $0.9z_p$ or from the lowest point 19 of actuator 16. The advantage of having the axial nodal point above the vertical center is that it reduces the mechanical work on the connection between actuator 16 and rigid member 20. It was found by the present inventor that such configuration significantly improves the efficiency.

Each of members 20 and 21 can be connected to actuator 16, for example, by a threaded rod 23 compatible with a threaded hole 25 in actuator 16. Members 20 and 21 can be connected to actuator 16 separately by two separate threaded rods 23, as illustrated in FIG. 1, or they can be jointly connected to actuator 16 by a single threaded rods 23 compatible with a threaded through hole passing through actuator 16 generally along the vertical direction.

The masses and sizes of members 20 and 21 can be calculated by computer simulations, for example, using a numerical finite element optimization. This can be done using commercial software, such as SolidWorks® and ANSYS®. The input to the computer simulation can be the vibration frequency of actuator 16 and the computer simulation program can vary the sizes and masses of members 20 and 21 until a predetermined criterion or set of criteria is met. For example, the criterion for the simulation can be that the overall vibration frequency of device 10 is substantially the same (e.g., within 10%) as the vibration frequency of actuator 16 when vibrated alone.

The computer simulation program can vary the contact area between actuator 16 and member 20, and/or between actuator 16 and member 21, until a predetermined criterion or set of criteria is met. In these embodiments, the criterion for the simulation can be that there is no detachment at the connecting surface between actuator 16 and member 20 and/or member 21 during vibration.

In various examples the masses, sizes and contact areas with actuator 16 are varied by the computer simulation program until a predetermined set of criteria is met. In these examples, the set of criteria preferably includes both the criterion that the overall vibration frequency of device 10 is substantially the same as the vibration frequency of actuator 16 when vibrated alone, and the criterion that that there is no detachment at the connecting surface between actuator 16 and member 20 and/or member 21 during vibration.

It was found by the present inventor that a judicious selection of the masses, sizes and contact areas of members 20 and 21 by means of computer simulations can provide a device with an overall vibration frequency that matches the vibration frequency of actuator 16, and good mechanical connection strength and durability between actuator 16 and members 20 and 21.

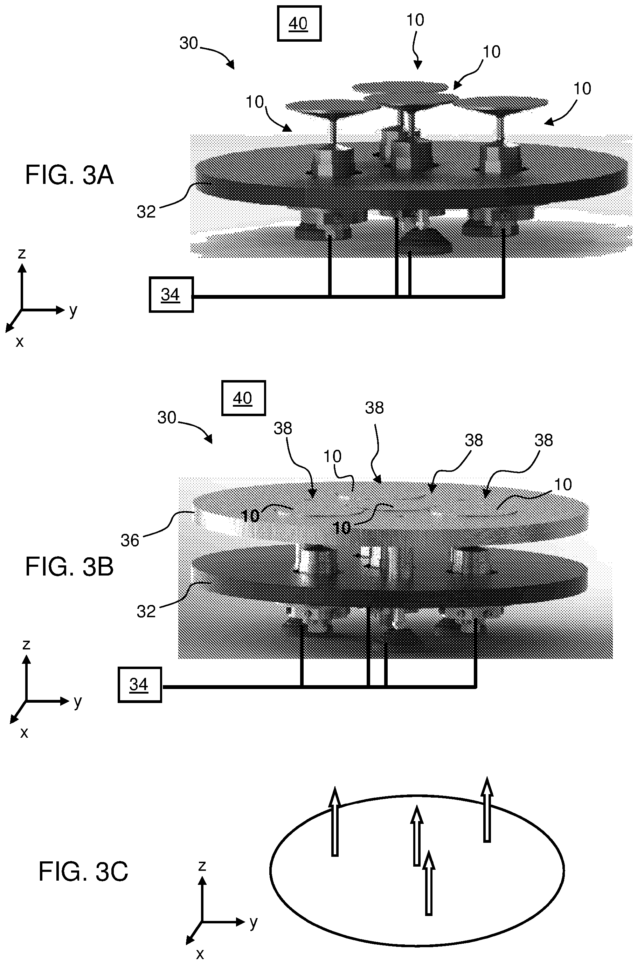

FIGs. 3A-B are schematic illustrations of a levitation system 30, in examples in which system 30 comprises a plurality of levitation devices such as device 10. Shown in FIGs. 3A-B are four levitation devices 10, but any number of levitation devices, including a single levitation device, can be incorporated in system 30. Devices 10 of system 30 are optionally and preferably arranged on a supportive surface 32. In some examples, system 30 comprises a stationary upper plate 36 formed with windows 38, wherein the upper surfaces of devices 10 are positioned at windows 38. Preferably, when the upper surfaces of devices 10 are undeformed, namely, when the actuators of devices 10 are inactive, the upper surfaces of devices 10 are above (e.g., 0.05-0.2 mm above) upper plate 36 (e.g., about 0.05-0.2 mm above upper plate 36).

In some examples, at least two or at least three of levitation devices 10 are arranged at equal distances from a point (e.g., a central point) on supportive surface 32. Optionally and preferably there is also a central levitation device, wherein the other levitation devices are arranged at equal distances from the central levitation device.

The levitation devices can be used for controlling the levitation height and/or tilt of object 12 (not shown, see FIG. 1). When it is desired to control the levitation height and tilt along both tilting directions (e.g., pitch and roll), system 30 preferably comprises at least three peripheral levitation devices 10, thereby establishing control over three degrees of freedom. When a fourth levitation device is included, for example, at the central location, the sag of object 12 can also be controlled. The directions of the forces applied to object 12 due to the vibrations of the four levitation devices 10 of system 30 are illustrated in FIG. 3C. The forces are applied by the medium (e.g., air) between object 12 and the respective levitation device by virtue of the near field vibration of the medium in response to the vibrations of the tapered members.

System 32 preferably comprises a controller 34 configured for activating at least one levitation device. Controller 34 is particularly useful when system 30 comprises more than one levitation devices. In these examples, controller 34 is configured for synchronizing vibrations of the respective vibration actuators to manipulate a position and/or tilt of object 12 (not shown, see FIG. 1). Controller 34 controls the vibrations such that the combination of forces that are applied to the object due to the vibrations of the individual levitation devices allows the object to assume the desired state.

Typically, controller 34 comprises an electronic circuit and a non-volatile memory medium readable by the circuit, wherein the memory medium stores program instructions which, when read by the circuit, cause the circuit to synchronize the vibrations.

System 30 optionally and preferably also comprises a sensing system 40 which senses the position (e.g., vertical and/or horizontal) and/or orientation and/or tilt of the object and transmits, preferably in a closed loop, sensing data to controller 34. Controller 34 receives the sensing data from system 40 and controls the respective actuators based on the data such as to correct the orientation and/or position of the object. Sensing system 40 can be of any type known in the art, including, without limitation, an optical sensing system, a radiofrequency sensing system. For example, system 40 can comprise one or more optical micrometers, such as the optical micrometer commercially available from Keyence Corporation of America in Woodcliff Lake, NJ.

In use, controller 34 receives an input position (e.g., levitation height) and an input orientation (e.g., tilt angles) from an external source (e.g., user interface, or a data processor). Based on the inputs, controller 34 calculates the operation parameters of the levitation devices, and operates the levitation devices based on the calculation. Controller 34 optionally also receives, preferably in a closed loop, position and/or orientation data from system 40 and recalculates the operation parameters so as to correct the position and/or orientation of the object to better match the inputs. Controller 34 can also receive the input position and input orientation dynamically so as to change the position and/or orientation continuously or intermittently, as desired.

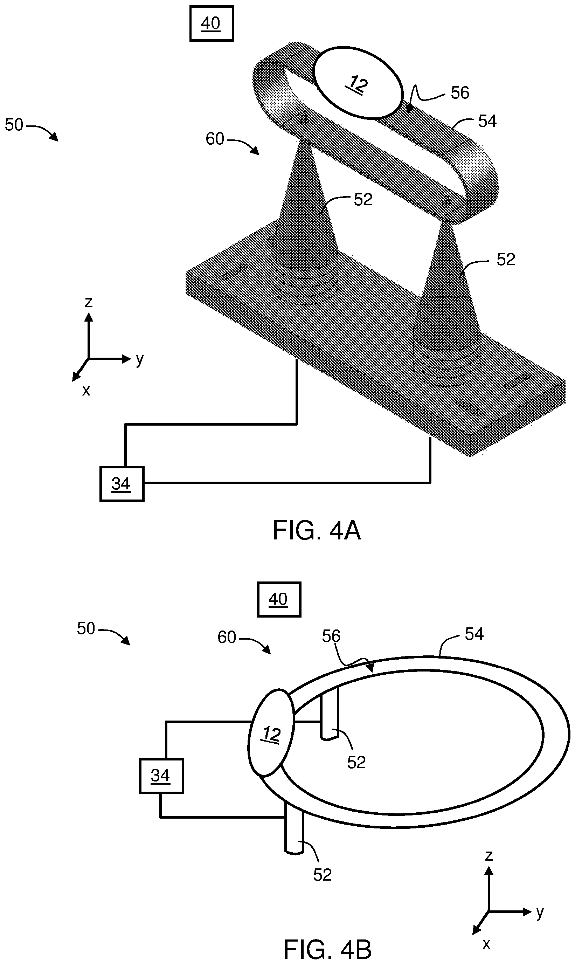

FIGs. 4A-B are schematic illustrations of a levitation system 50 for levitating an object 12, in embodiments of the invention in which levitation is effected by traveling waves. Levitation system comprises one or more levitation devices 60. In the illustrations of FIGs. 4A-B, system 50 comprises a single levitation device 60, but use of more than one levitation devices is also contemplated.

Device 60 comprises a plurality of vibration actuators 52 and a band structure 54, shaped as a loop and being coupled to the vibration actuators 52. Band structure 54 can form a vertical loop, as illustrated in FIG. 4A or a horizontal loop as illustrated in FIG. 4B. In any event, band structure 54 has a horizontal surface 56 above which object 12 is levitated. The loop shape of band structure 54 has at least two normal modes of vibration which can be driven by actuators 52.

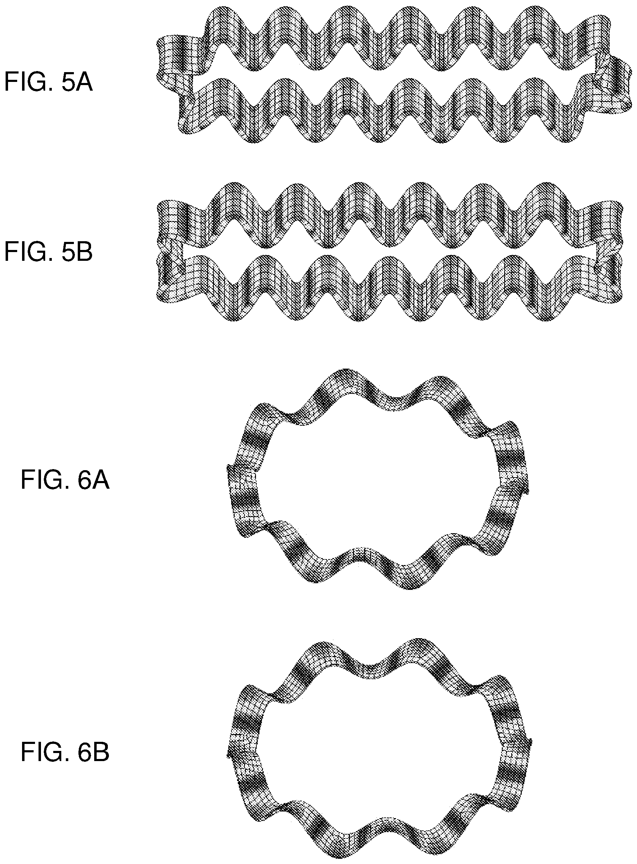

A vibration at a normal mode is also referred to in the literature as "resonance." Two normal modes of band structure 54 when the structure forms a vertical loop are illustrated in FIGs. 5A-B, and two normal modes of band structure 54 when the structure forms a horizontal loop are illustrated in FIGs. 6A-B. For a vertical loop (FIGs. 5A-B), one of the two normal modes is optionally and preferably symmetric (FIG. 5A), and the other normal mode is optionally and preferably anti-symmetric (FIG. 5B). The symmetry and anti-symmetry is realized with respect to an axis parallel, for example, to a diameter of the loop. For a horizontal loop (FIGs. 6A-B), one of the two normal modes is phase shifted (e.g., by a quarter of the wavelength of the generated wave) with respect to the other normal mode.

Each of the normal modes, by itself, corresponded to a standing mechanical wave, so that when band structure 54 is driven to vibrate according to one of the normal mode, a standing mechanical wave is generated along structure 54. It was found by the present inventors that band structure 54 can be driven by the actuators 52 to effect a vibration state which is a combination of two normal modes, such as, but not limited to, a symmetric normal mode and an anti-symmetric normal mode, or a first normal mode and a second normal mode, wherein the second normal mode is phase shifted (e.g., by a quarter of wavelength relative to the first normal mode). When structure 54 is driven to such a vibration state, a traveling mechanical wave is generated along structure 54. It was demonstrated by the present inventor that a traveling mechanical wave can be generated at amplitudes which are within the resonance bandwidth corresponding to at least one of the normal modes of structure 54.

As used herein, "amplitude within the resonance bandwidth" refers to amplitude which is not lower by more than 3dB from the amplitude at resonance.

The traveling mechanical wave of the present embodiments is at amplitude which is within the resonance bandwidth corresponding to at least one of the normal modes of structure 54, is in the sense that the vibration state of structure 54 is characterized by a frequency and amplitude corresponding to an input power of the vibration actuator, wherein the amplitude is lower, by no more than 3dB, than the amplitude that would have been exhibited by the same structure had the structure been driven using the same input power to vibrate at the same frequency but at one of the normal modes.

Typically, the amplitude of the vibration of band structure 54 is at least 10 times or at least 50 times or at least 100 times or at least 200 times larger than the amplitude of the vibration of actuators 52. Typical ratios between the amplitude of the vibration of band structure 54 and the amplitude of the vibration of actuators 52 are from about 10 to about 800 or from about 100 to about 600 or from about 200 to about 600, e.g., about 400 or more.

The amplitude of the vibration of band structure 54 can be measured, for example, using a commercial optical micrometer or any other commercial instrument suitable for measuring deviation from planarity.

System 50 optionally and preferably comprises controller 34, which synchronizes vibrations of vibration actuators 52 to generate traveling mechanical waves in band structure 54. Controller 34 can comprises an electronic circuit and a non-volatile memory medium that stores program instructions which, when read by the circuit, cause the circuit to synchronize the vibrations.

In some embodiments, controller 34 can synchronize the vibrations to effect a vibration state which is a combination of two normal modes of band structure 54, for example, a symmetric mode and an anti- symmetric mode, or two phase shifted normal modes. In some embodiments of the invention the amplitude of the vibration of band structure 54 is higher than the amplitude of the vibration of actuators 52, as further detailed hereinabove. In some embodiments, the traveling mechanical waves are at amplitude which is within the resonance bandwidth corresponding to at least one of the normal modes of structure 54.

In various exemplary embodiments of the invention the wavelength of the generated traveling wave is sufficiently short, e.g., at most 10 cm or at most 9 cm or at most 8 cm or at most 7 cm or at most 6 cm or at most 5 cm, e.g., about 4 cm or less.

Controller 34 is configured, by means of the stored program instructions, to synchronize the vibrations of actuators 52 to manipulate object 12. Since a traveling wave is generated in band structure 54, controller 34 can establish a translation motion of object 12 by controlling the direction and/or magnitude of the velocity of the traveling wave. Each band structure of system 50 can be used to establish a translation motion along the direction of surface 56 (linear translation motion when structure 54 forms a vertical loop, and curved translation motion when structure 54 forms a horizontal loop). In some embodiments, the amplitude of the generated wave is varied by controller 34 so as to control the levitation height of object 12. In these embodiments, the generated wave can be a standing wave.

Also contemplated, are embodiments in which controller 34 synchronizes the vibrations of actuators 52 to simultaneously generate both standing and traveling waves, thereby allowing system 50 to provide both levitation and translational motion. In these embodiment, it is not necessary for the amplitude of the traveling wave to be within the resonance bandwidth (although this is also contemplated), since when the object is levitated by the standing wave, translation motion can be induced even when the amplitude of the traveling wave is small.

System 50 optionally and preferably also comprises a sensing system 40 which senses the position and/or orientation and/or tilt of the object and transmits, preferably in a closed loop, sensing data to controller 34, as further detailed hereinabove. In use, controller 34 receives data from system 40 and operates the levitation devices as further detailed hereinabove.

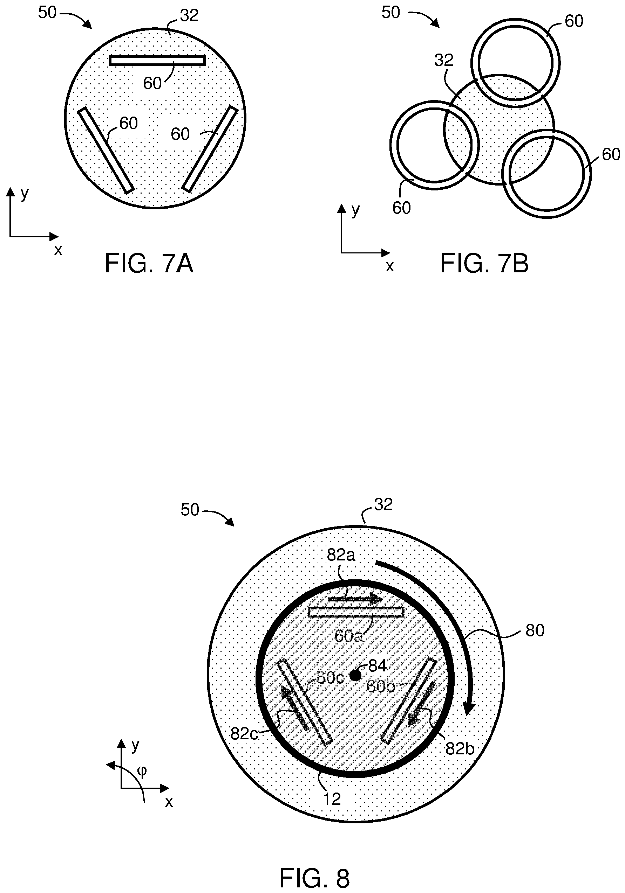

FIGs. 7A-B are schematic illustrations of top views of levitation system 50 in embodiments of the invention in which system 50 comprises more than one levitation device 60 that generates traveling waves. Levitation devices 60 can be arranged on a supportive surface 32. Two or more of levitation devices 60 are optionally and preferably arranged at equal distances from a point (e.g., a central point) on supportive surface 32. For clarity of presentation, various components that are presented in FIGs. 4A-B such as controller 34, sensing system 40 and actuators 52 are not explicitly shown in FIGs. 7 A and 7B. Embodiments in which at least one of these components is optionally and preferably included in system 50 are also contemplated. The principles and operations of these components are the same as described above. Therefore, one of ordinary skills in the art, provided with the details described herein would know how to add these components to the system illustrated in FIGs. 7A-B.

FIG. 7A shows an embodiment in which system 50 comprises three levitation devices 60 each having a band structure that forms a vertical loop (perpendicular to the plane of FIG. 7A), and FIG. 7B shows an embodiment in which system 50 comprises three levitation devices 60 each having a band structure that forms a horizontal loop. While the embodiments shown in FIGs. 7A-B comprises three levitation devices of the same type, this need not necessarily be the case since in some embodiments the number of levitation devices can be other than three, and in some embodiments it is not necessary for all the levitation devices to be of the same type.

Controller 34 (not shown in FIGs. 7A-B, see FIGs. 4A-B) communicates with each vibration actuator of each of the levitation devices and is configured, by means of the stored program instructions to synchronize the vibrations of the actuators to manipulate the object. Use of several levitation devices allows manipulating the object in several degrees of freedom. Since each of levitation devices 60 can establish translational motion and can also control the levitation height, use of three levitation devices such as devices 60 allows manipulation of the object in six degrees of freedom.

As a representative example, the traveling waves generated in the band structures of devices 60 can be used to rotate the object about a vertical axis (perpendicular to FIGs. 7A-B). Such a rotation can be established by operating two or more of devices 60 to exhibit traveling waves propagating in a direction along which the azimuthal angle varies monotonically and similarly. For example, in some embodiments each of devices 60 can exhibit traveling waves propagating in a direction along which the azimuthal angle increases, and in some embodiments each of devices 60 can exhibit traveling waves propagating in a direction along which the azimuthal angle decreases.

FIG. 8 schematically illustrates clockwise rotation of object 12 about a vertical axis 84 (along or parallel to the z axis, perpendicular to the plane of FIG. 8) by generating traveling waves in band structures of three levitation devices 60a, 60b, 60c. Devices 60a, 60b, 60c are arranged to surround axis 84 (*e.g.,* at equal distances from the axis 84). The rotation direction is shown by arrow 80, and the propagation directions of the traveling waves in the band structures of devices 60a, 60b and 60c, are shown by arrows 82a, 82b and 82c, respectively. In the representative illustration, which is not to be considered as limiting, the azimuthal angle $\phi$ decreases along each of arrows 82a, 82b and 82c, so that each of devices 60a, 60b and 60c contributes to the rotation of object 12 along direction 80.

The manipulation of the object by controller 34 can optionally and preferably include receiving data from system 40 (not shown in FIGs. 7A and 7B, see FIGs, 4A and 4B), and operating the levitation devices as further detailed hereinabove.

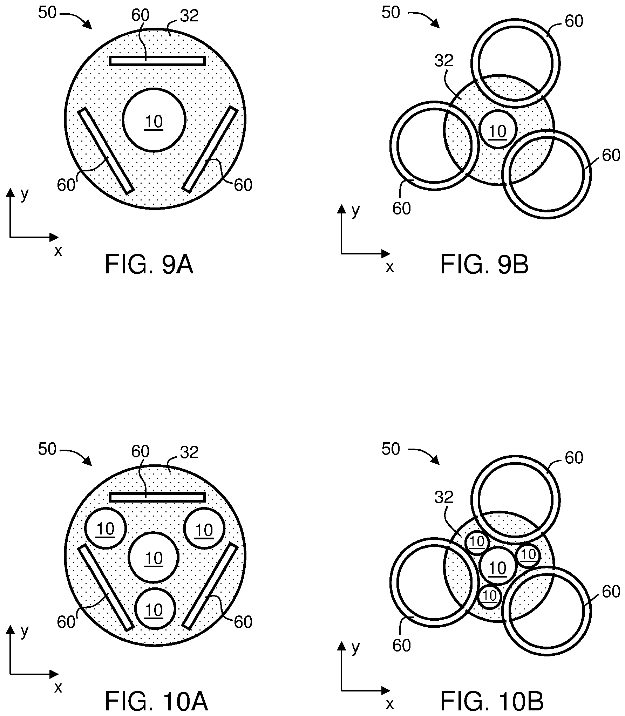

FIGs. 9A-B are schematic illustrations of top views of levitation system 50 in embodiments of the invention in which system 50 comprises several levitation devices 60, and levitation device 10. Levitation devices 10 and 60 can be arranged on a supportive surface 32. Levitation devices 60 are optionally and preferably arranged at equal distances from levitation device 10. For clarity of presentation, various components that are presented in FIGs. 1, 3A-B and 4A-B such as controller 34, sensing system 40, upper plate 36, and actuators 52 are not explicitly shown in FIGs. 9A and 9B. Embodiments in which at least one of these components is optionally and preferably included in system 50 are also contemplated. The principles and operations of these components are the same as described above. Therefore, one of ordinary skills in the art, provided with the details described herein would know how to add these components to the system illustrated in FIG. 9A and 9B.

FIG. 9A shows an embodiment in which each of levitation devices 60 has a band structure that forms a vertical loop (perpendicular to the plane of FIG. 9A), and FIG. 9B shows an embodiment in which each of levitation devices 60 has a band structure that forms a horizontal loop.

In the embodiments shown in FIG. 9A-B, levitation device 10 is operated by controller 34 to exhibit a three-dimensional deformation, and levitation devices 60 are operated by controller 34 to exhibit a traveling wave, as further detailed hereinabove. In various exemplary embodiments of the invention controller 34 operates levitation device 10 to control the levitation height and/or tilt of the object, and levitation devices 60 to establish translational motion of the object.

FIGs. 10A-B are schematic illustrations of top views of levitation system 50 in embodiments of the invention in which system 50 comprises several levitation devices 60, and several levitation devices 10. Levitation devices 10 and 60 can be arranged on a supportive surface 32. Levitation devices 60 are optionally and preferably arranged at equal distances from a central levitation device 10. Additional levitation devices 10 are optionally and preferably arranged at equal distances from central levitation device 10.

For clarity of presentation, various components that are presented in FIGs. 1, 3A-B and 4A-B such as controller 34, sensing system 40, upper plate 36, and actuators 52 are not explicitly shown in FIGs. 10A and 10B. Embodiments in which at least one of these components is optionally and preferably included in system 50 are also contemplated. The principles and operations of these components are the same as described above. Therefore, one of ordinary skills in the art, provided with the details described herein would know how to add these components to the system illustrated in FIG. 10A and 10B.

FIG. 10A shows an embodiment in which each of levitation devices 60 has a band structure that forms a vertical loop (perpendicular to the plane of FIG. 10A), and FIG. 10B shows an embodiment in which each of levitation devices 60 has a band structure that forms a horizontal loop.

In the embodiments shown in FIG. 10A-B, levitation devices 10 are operated by controller 34 to exhibit a three-dimensional deformation, and levitation devices 60 are operated by controller 34 to exhibit a traveling wave, as further detailed hereinabove. In various exemplary embodiments of the invention controller 34 operates levitation devices 10 to control the levitation height and/or tilt and/or sag of the object, and levitation devices 60 to establish translational motion of the object.

The present embodiments also contemplate a method suitable for levitating an object. The method comprises placing the object on a levitation system having at least one levitation device, and activating at least one of the levitation devices to levitate the object. The levitation system can be of any type known in the art. In some embodiments the levitation system is an acoustic levitation system. In some embodiments, the levitation system comprises one or more of levitation devices 10, in some embodiments the levitation system comprises one or more of levitation devices 60, and some embodiments the levitation system comprises one or more of levitation devices 10 and one or more of levitation devices 60, as further detailed hereinabove.

Use of other levitation systems, such as, but not limited to, a levitation system that employs electrostatic forces or electrodynamic force or magnetic forces or optical pressure or aerodynamics for effecting the levitation is also contemplated.

When the levitation system comprises one or more of levitation devices 10, the method optionally and preferably operate the levitation device to effect a three- dimensional deformation, characterized by a deformation amplitude of at least X and a vibration frequency of at least F, wherein X and F are selected to effect levitation characterized by a squeeze-number σ, which is at least 10. A mathematical expression of the squeeze-number σ is provided in EQ. 1 of the Examples section that follows.

For F which is above or equal to 10 kHz, X is at least 0.5 $\mu$m or at least 1 $\mu$m or at least 2 $\mu$m or at least 5 $\mu$m, and for F which is less than 10 kHz, X is at least 10 $\mu$m. For objects having diameters above 100 mm, F is preferably at least 20 kHz and X is preferably at least 0.5 $\mu$m. For objects having diameters from about 10 mm to about 30 mm, F is preferably at least 20 kHz and X is preferably at least 2 $\mu$m.

When the levitation system comprises one or more of levitation devices 60, in some embodiments, the method operates the levitation device to generate traveling wave, wherein the amplitude of the traveling wave is higher than the amplitude of the actuators as further detailed hereinabove. In some embodiments, the traveling mechanical waves are at amplitude with the resonance bandwidths as further detailed hereinabove.

In some embodiments, the method operates the levitation device to simultaneously generate both standing and traveling waves. In these embodiments, it is not necessary for the amplitude of the traveling wave to be within the resonance bandwidth as further detailed hereinabove.

The method optionally and preferably operates the levitation device to generate traveling wave at a sufficiently short wavelength as further detailed hereinabove. The method can optionally and preferably also operate the levitation devices for manipulating the object. For example, levitation devices 10 can be operated to manipulate the height and/or tilt and or sag of the object, and levitation devices 60 can be operated to establish translation motion and/or to rotate the object about a vertical axis, as further detailed hereinabove.

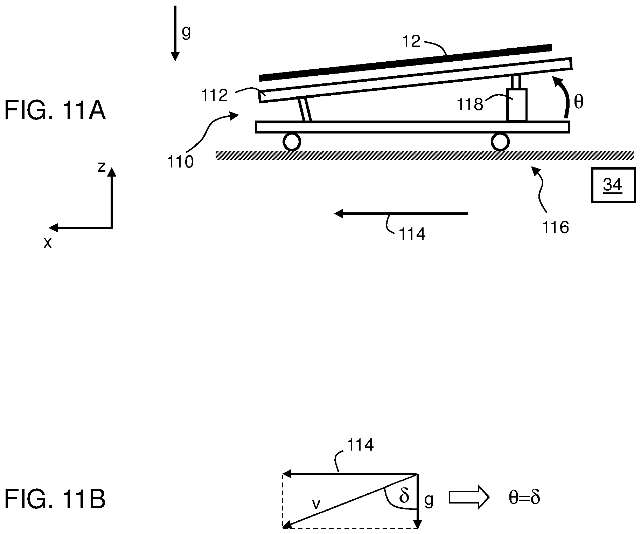

In some embodiments of the present invention the surface over which the object is levitated is accelerated by the method along the horizontal direction. These embodiments are illustrated in FIG. 11A which illustrates a levitation system 110 having a surface 112 above which object 12 is levitate. System 110 can be similar to any of systems 30 and 50 described above, or it can be another type of levitation system, as desired. For example, if desired, system 110 can employ electrostatic forces or electrodynamic forces or magnetic forces or optical pressure or aerodynamics or any combination thereof with or without levitation by near field mechanical waves.

In the present example, system 110, particularly surface 112 is accelerated horizontally along the x-direction as indicated by arrow 114. Simultaneously with the horizontal acceleration 114, surface 112 is preferably tilted at an angle Θ. The acceleration of surface 112 can be done by a locomotion mechanism 116, such as a conveyor or the like. The tilting can be established by means of a tilter 118 such as a telescopic lift of the like. Any of the locomotion mechanism and tilter can be controlled by controller 34, which is provided with suitable circuit, and optionally readable memory medium storing suitable program instructions. In various exemplary embodiments of the invention Θ is approximately or equal to the angular deviation from verticality of a sum of the gravitational acceleration vector (shown as an arrow g along the -z direction) and the horizontal acceleration vector 114. A representative example of a procedure suitable for calculating Θ is illustrated in FIG. 11B. The acceleration vector 114 and the gravitational acceleration vector are summed to provide a sum vector v. The deviation from verticality δ of the vector v is then calculated as the angle between the vector v and the vector g. The tilt angle Θ is then set to be the same as the deviation angle 6. The deviation angle δ can, in some embodiments of the invention, be calculated without actually summing acceleration vector 114 and gravitational acceleration vector g. For example, the deviation angle δ can be calculated based on the ratio between the magnitudes of acceleration vector 114 and gravitational acceleration vector g.

It was found by the present inventor that tilting surface 112 at an angle Θ which is about the angular deviation from verticality of the sum of the gravitational acceleration vector g and the horizontally acceleration vector 114, significantly reduce the effect of the acceleration on the lateral location of object 12 relative to surface 112. This is because the object 12 experiences an inertial force that is generally perpendicular to surface 112, as will now be explained. In the absence of acceleration, object 12 experiences, in addition to the levitation force in the +z direction, a gravitational force in the -z direction. In this case the gravitational force is anti-parallel to the levitation force. Once the horizontal acceleration begins, for example, along the +x direction, object 112 experiences, in addition to the levitation force and the gravitational force, an inertial horizontal force in the opposite horizontal direction (the -x direction, in the present example). The sum of the inertial horizontal force and gravitational force deviates from the vertical direction. This deviation is the same as the angular deviation δ described above. Tilling surface 112 at the same extent ensures that the object experiences only forces that are generally perpendicular to the surface, thus effectively restores the situation in the absence of acceleration.

Thus, in use controller 34 receives input pertaining to the acceleration of surface 112 (e.g., via a user interface, or from an accelerometer, or directly from mechanism 116) and calculates the tilt angle Θ based on the input acceleration. Controller 34 then operates tilter 118 to tilt surface 112 at tilt angle Θ.

As used herein the term "about" refers to ± 10 %.

The word "exemplary" is used herein to mean "serving as an example, instance or illustration." Any embodiment described as "exemplary" is not necessarily to be construed as preferred or advantageous over other embodiments and/or to exclude the incorporation of features from other embodiments.

The word "optionally" is used herein to mean "is provided in some embodiments and not provided in other embodiments." Any particular embodiment of the invention may include a plurality of "optional" features unless such features conflict.

The terms "comprises", "comprising", "includes", "including", "having" and their conjugates mean "including but not limited to". The term "consisting of means "including and limited to".

The term "consisting essentially of" means that the composition, method or structure may include additional ingredients, steps and/or parts, but only if the additional ingredients, steps and/or parts do not materially alter the basic and novel characteristics of the claimed composition, method or structure.

As used herein, the singular form "a", "an" and "the" include plural references unless the context clearly dictates otherwise. For example, the term "a compound" or "at least one compound" may include a plurality of compounds, including mixtures thereof.

Throughout this application, various embodiments of this invention may be presented in a range format. It should be understood that the description in range format is merely for convenience and brevity and should not be construed as an inflexible limitation on the scope of the invention. Accordingly, the description of a range should be considered to have specifically disclosed all the possible sub ranges as well as individual numerical values within that range. For example, description of a range such as from 1 to 6 should be considered to have specifically disclosed sub ranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range.

Whenever a numerical range is indicated herein, it is meant to include any cited numeral (fractional or integral) within the indicated range. The phrases "ranging/ranges between" a first indicate number and a second indicate number and "ranging/ranges from" a first indicate number "to" a second indicate number are used herein interchangeably and are meant to include the first and second indicated numbers and all the fractional and integral numerals therebetween.

Various embodiments and aspects of the present invention as claimed in the claims section below find experimental support in the following examples.

EXAMPLES

Reference is now made to the following examples, which together with the above descriptions illustrate some embodiments of the invention in a non limiting fashion.

### *Practical Considerations*

The phenomenon of near-field acoustic levitation of an object is driven by the vibration of a surface at a frequency, $\omega$ . The levitation height is controlled by several physical parameters including, the squeeze number defined as:

$$\sigma = \frac{12\mu\omega r_0^2}{P_a h_0^2} \qquad\qquad \text{(EQ. 1)}$$

where $\mu$ is the dynamic viscosity of the fluid, $P_a$ is the ambient pressure, $h_0$ is the average air gap, and $r_0$ is the radius of the air layer that is between device 10 and the object.

The squeeze-number measures how much the fluid entrapped in the gap between the levitated object and the vibrated surface is squeezed.

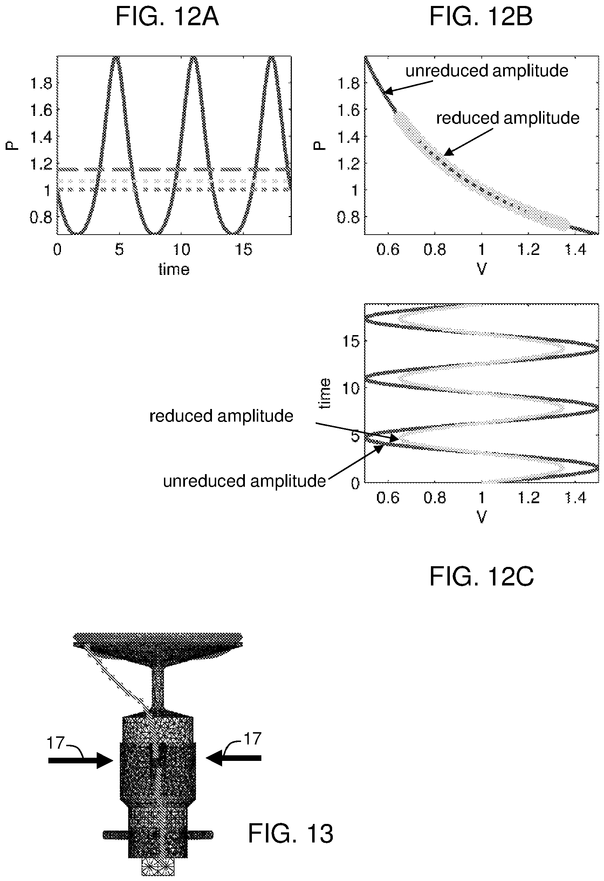

FIGs. 12A-C show a simplified relationship between volume and pressure, (Boil' s law) to illustrate the phenomenon of near-field acoustic levitation. FIG. 12A shows that a sinusoidal change of the entrapped gas' volume gives rise to non- sinusoidal variation of pressure as a function of time whose average (long dash line) is higher than the ambient pressure (dotted line at P=1). FIG. 12B shows the pressure- volume relation, for unreduced and reduced amplitude oscillations leading to lower elevation of the mean pressure. The unreduced and reduced volume oscillations are shown in FIG. 12C. The reduced amplitude is lower than the unreduced amplitude by 30%.

The present example relates to a vibration driven acoustic levitation by means of device 10 as illustrated in FIG. 1, with a piezoelectric vibration actuator 16 that is fed by a high-voltage highfrequency signal that makes the piezoelectric deform at amplitude that is less than 1 $\mu$m. Rod 18 and member 14 amplify the displacement enforced by the piezoelectric disks. The present inventor found that for a frequency of about 28 kHz rod 18 and member 14 can amplify the displacement by a factor of at least 25.

The levitation takes place because of air viscosity and compressibility that prevent the air from escaping the narrow gap between the vibrating surface and the levitated object. This occurs at high frequencies and small gaps where

$\sigma \gg 1$.

The advantage of the device shown in FIG. 1 is that it can be used for acoustic levitation of large objects. Unlike conventional techniques that employ one- dimensional structures, e.g., shaped as a horn, the device of the present embodiments enhances the motion of the vibrating surface by considering its 3 dimensional configuration.

In various exemplary embodiments of the invention rod 18 and the top surface of member 14 are designed to resonate at the applied frequency (28 KHz in the present example). Optionally and preferably device 10 has a near zero impedance. For example, the impedance of device 10 can be at least 100 times smaller than a rigid object having the same size. This allows device 10 to match many types of vibration actuators and can produce large deformations.

FIG. 13 is a schematic illustration of the axial elongation at the centerline. The elongation is illustrated by radially displaced squares. Shown are the unreformed (black) and maximally deformed (blue) states. Also shown is the location 17 of the axial nodal point of actuator 16. As shown, the deformations are largest at the top surface of member 14 so that device 10 provides mechanical amplification. Referring again to FIGs. 12A-C larger oscillations correspond to higher mean pressure hence also to higher levitation height.

### *Experiments*

A 300 mm silicon wafer was placed above a single levitation device manufactured according to some embodiments of the present invention as described above with respect to FIG. 1. The levitation device successfully levitated the silicon wafer.

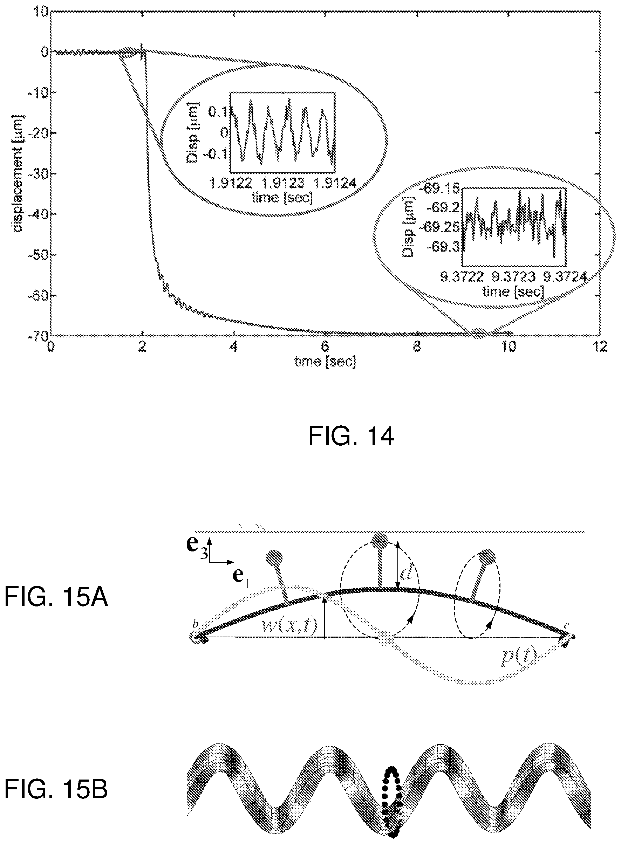

In order to determine the levitation height, a top laser measurement system was employed. The position of a laser beam in the z-direction was measured during levitation and after the high frequency driving voltage has been stopped. Once levitation has ceased, the wafer drops to full contact at 70 micro-meters below. The mechanical amplification allowed operating the levitation system at low input power (less than 20 W per actuator, in the present example). FIG. 14 shows the displacement in $\mu$m as a function of the time. The insets are magnified graphs of marked sections during levitation (left inset) and at full contact.

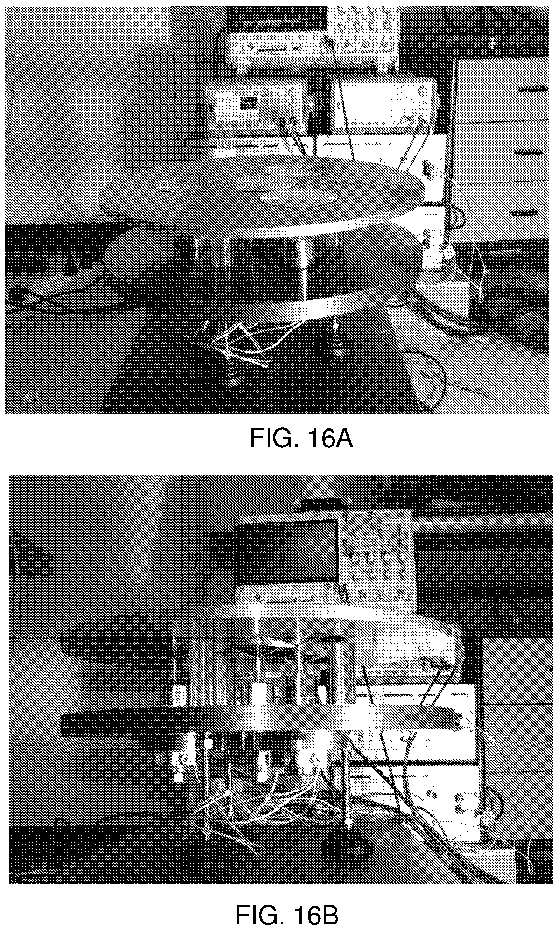

A prototype system including four levitation devices and an upper plate according to FIG. 3B, was also manufactured and successfully operated. Images of the prototype system, from two different viewpoints, are shown in FIGs. 16A and 16B.

### *Manipulating The Levitated Object*

The present embodiments employ traveling waves for establishing translation establish of the object. The traveling waves of vibration are formed on the surface of a band structure shaped as a vertical or horizontal loop (see surface 56 of band structure 54 in FIGs. 4 A and 4B). The advantage of the band structure of the present embodiments over conventional systems is that in conventional systems traveling waves fail to create large amplitudes. The reason is that large amplitude vibrations occur at normal mode frequencies, where standing waves prevail. The loop shape of the present embodiments allows generating traveling waves, generally at resonance.

In some embodiments of the invention the displacement of surface 56, when driven at resonance by actuators 52, is dominated by a combination of the two modes shown in FIGs. 5A-B or FIGs. 6A-B). The actuators driving the band structure can be tuned to yield:

$$w(x,t) = \phi_{sym}(x)sin\omega t + \phi_{asym}(x)cos\omega t,$$

$$\phi_{sym}(x) = W_0 sin\frac{2\pi x}{\lambda},$$

$$\phi_2(x) = W_1 cos\frac{2\pi x}{\lambda} \qquad \qquad (EQ. 2)$$

FIG. 15A is a schematic illustration of the kinematics of points on surface 56, and FIG. 15B illustrates numerical simulation results of the wave generated in the band structure. As shown, a material point exhibits an elliptical orbit. This motion creates propulsive force through the viscosity of the air layer. The magnitude of the force depends primarily on the amplitude and wavelength. In various exemplary embodiments of the invention the wavelength is at most 10 cm or at most 9 cm or at most 8 cm or at most 7 cm or at most 6 cm or at most 5 cm, *e.g.,* about 4 cm or less.

Although the invention has been described in conjunction with specific embodiments thereof, it is evident that many alternatives, modifications and variations will be apparent to those skilled in the art. Accordingly, it is intended to embrace all such alternatives, modifications and variations that fall within the scope of the appended claims.

**Claims**

1. A levitation system (50), comprising:

   at least one levitation device (60) having a plurality of vibration actuators (52), and a band structure (54), shaped as a loop and being coupled to said vibration actuators (52); and
   a controller (34), having an electronic circuit and a non-volatile memory medium readable by said circuit, wherein said memory medium stores program instructions which, when read by said circuit, cause said circuit to synchronize vibrations of said vibration actuators (52) to generate in said band structure (54) traveling mechanical waves.

2. The system (50) of claim 1, wherein said traveling mechanical waves are at amplitude which is within a resonance bandwidth corresponding to at least one normal mode of said band structure (54).

3. The system (50) of claim 1 or 2, wherein said loop is a vertical loop or horizontal loop.

4. The system (50) of any preceding claim, wherein said at least one levitation device (60) comprises a plurality of levitation devices (60) arranged on a supportive surface (32), and wherein said program instructions cause said circuit to synchronize vibrations of actuators (52) of respective levitation devices (60) to manipulate an object (12) levitated above said levitation devices (60) in six degrees of freedom.

5. The system (50) of claim 4, wherein said plurality of levitation devices (60) is arranged at equal distances from a point on said supportive surface (32).

6. The system (50) of any preceding claim, further comprising at least one additional levitation device (10) having a flexible tapered member (14) physically coupled to a vibration actuator (16) via a flexible rod (18), wherein a widest surface (14a) of said tapered member (14) is responsive to a vibration of said actuator (16) by exhibiting a three-dimensional deformation.

7. The system (50) of claim 6, wherein said program instructions cause said circuit to synchronize vibrations of actuators (16, 52) of respective levitation devices (60) and respective additional levitation devices (10) to manipulate an object (12) levitated above said levitation devices (60) in six degrees of freedom.

8. The system (50) of claim 7, further comprising a sensing system (40), wherein said program instructions cause said circuit to receive from said sensing system (40) data pertaining to orientation, tilt and/or position of said object (12) and to synchronize said vibrations responsively to said data.

9. A method of levitating an object (12), comprising:

   placing the object (12) on a surface (112) of levitation system (110) so as to levitate the object (12) above said surface (112);
   horizontally accelerating said surface (112); and
   simultaneously with said horizontal acceleration, tilting said surface (112) at an angle that equals an inclination angle of a vector sum of a gravitational acceleration and said horizontal acceleration.

**Patentansprüche**

1. Schwebesystem (50), umfassend:
   Zumindest eine Schwebevorrichtung (60) mit einer Vielzahl von Schwingungsaktoren (52) und einer Bandstruktur (54), die als Schleife gestaltet und an die Schwingungsaktoren (52) gekoppelt ist; und
   eine Steuereinheit (34), mit einer elektronischen Schaltung und einem nichtflüchtigen Speichermedium, das von der Schaltung lesbar ist, wobei das Speichermedium Programmbefehle speichert, die, wenn von der Schaltung gelesen, bewirken, dass die Schaltung Schwingungen der Schwingungsaktoren (52) synchronisiert, um wandernde mechanische Wellen in der Bandstruktur (54) zu generieren.

2. System (50) nach Anspruch 1, wobei die wandernden mechanischen Wellen bei Amplitude sind, die innerhalb einer Resonanzbandbreite liegt, die zumindest einem normalen Modus der Bandstruktur (54) entspricht.

**3.** System (50) nach Anspruch 1 oder 2, wobei die Schleife eine vertikale Schleife oder eine horizontale Schleife ist.

**4.** System (50) nach einem vorhergehenden Anspruch, wobei die zumindest eine Schwebevorrichtung (60) eine Vielzahl von Schwebevorrichtungen (60) umfasst, die auf einer Auflagefläche (32) angeordnet sind und, wobei die Programmbefehle bewirken, dass die Schaltung Schwingungen der Aktoren (52) jeweiliger Schwebevorrichtungen (60) synchronisiert, um ein Objekt (12) zu manipulieren, das über die Schwebevorrichtungen (60) in sechs Freiheitsgraden schweben gelassen wird.

**5.** System (50) nach Anspruch 4, wobei die Vielzahl von Schwebevorrichtungen (60) in gleichen Abständen von einem Punkt auf der Auflagefläche (32) angeordnet ist.

**6.** System (50) nach einem vorhergehenden Anspruch, das ferner zumindest eine zusätzliche Schwebevorrichtung (10) mit einem flexiblen verjüngten Element (14) aufweist, das physikalisch an einen Schwingungsaktor (16) über eine flexible Stange (18) gekoppelt ist, wobei eine breiteste Oberfläche (14a) des verjüngten Elements (14) auf eine Schwingung des Aktors (16) anspricht, indem sie eine dreidimensionale Verformung zeigt.

**7.** System (50) nach Anspruch 6, wobei die Programmbefehle bewirken, dass die Schaltung Schwingungen von Aktoren (16, 52) der jeweiligen Schwebevorrichtungen (60) und jeweiligen zusätzlichen Schwebevorrichtungen (10) synchronisiert, um ein Objekt (12) zu manipulieren, das in sechs Freiheitsgraden über die Schwebevorrichtungen (60) schweben gelassen wurde.

**8.** System (50) nach Anspruch 7, das ferner ein Abtastsystem (40) umfasst, wobei die Programmbefehle bewirken, dass die Schaltung vom Abtastsystem (40) Daten empfängt, die Orientierung, Neigung und /oder Position des Objekts (12) betreffen und, um die Schwingungen in Abhängigkeit von den Daten zu synchronisieren.

**9.** Verfahren zum Schweben eines Objekts (12), umfassend:
Platzieren des Objekts (12) auf eine Oberfläche (112) des Schwebesystems (110), um das Objekt (12) über der Oberfläche (112) schweben zu lassen;
Horizontales Beschleunigen der Oberfläche (112); und gleichzeitig mit der horizontalen Beschleunigung, Neigen der Oberfläche (112) in einem Winkel, der einem Neigungswinkel einer Vektorsumme einer Gravitationsbeschleunigung und der horizontalen Beschleunigung gleicht.

**Revendications**

**1.** Un système de lévitation (50), comprenant :

un ou plusieurs dispositifs de lévitation (60) ayant une pluralité d'actionneurs de vibration (52), et une structure de bande (54) en forme de boucle et étant accouplée auxdits actionneurs de vibration (52) ; et
un dispositif de commande (34), ayant un circuit électronique et un support de mémoire non volatile lisible par ledit circuit, dans lequel ledit support de mémoire mémorise des instructions de programme qui, lorsqu'elles sont lues par ledit circuit, amènent ledit circuit à synchroniser les vibrations desdits actionneurs de vibration (52) pour générer dans ladite structure de bande (54) des ondes mécaniques progressives.

**2.** Le système (50) selon la revendication 1, dans lequel lesdites ondes mécaniques progressives sont à une amplitude qui est dans la plage d'une bande passante de résonance correspondant à au moins un mode normal de ladite structure de bande (54).

**3.** Le système (50) selon la revendication 1 ou 2, dans lequel ladite boucle est une boucle verticale ou une boucle horizontale.

**4.** Le système (50) selon l'une quelconque des revendications précédentes, dans lequel ledit ou lesdits dispositifs de lévitation (60) comprennent une pluralité de dispositifs de lévitation (60) agencés sur une surface de support (32) et dans lequel lesdites instructions de programme amènent ledit circuit à synchroniser les vibrations d'actionneurs (52) de dispositifs de lévitation respectifs (60) pour manipuler un objet (12) maintenu en sustentation au-dessus desdits dispositifs de lévitation (60) dans six degrés de liberté.

**5.** Le système (50) selon la revendication 4, dans lequel ladite pluralité de dispositifs de lévitation (60) sont agencés à des distances égales d'un point sur ladite surface de support (32).

6. Le système (50) selon l'une quelconque des revendications précédentes, comprenant en outre un ou plusieurs dispositifs de lévitation supplémentaires (10) ayant un élément conique souple (14) accouplé physiquement à un actionneur de vibration (16) par une tige souple (18), dans lequel une surface la plus large (14a) dudit élément conique (14) réagit à une vibration dudit actionneur (16) en présentant une déformation tridimensionnelle.

7. Le système (50) selon la revendication 6, dans lequel lesdites instructions de programme amènent ledit circuit à synchroniser les vibrations d'actionneurs (16, 52) de dispositifs de lévitation respectifs (60) et de dispositifs de lévitation supplémentaires respectifs (10) pour manipuler un objet (12) maintenu en sustentation au-dessus desdits dispositifs de lévitation (60) dans six degrés de liberté.

8. Le système (50) selon la revendication 7, comprenant en outre un système de détection (40), dans lequel lesdites instructions de programme amènent ledit circuit à recevoir dudit système de détection (40) des données relatives à l'orientation, l'inclinaison et/ou la position dudit objet (12) et à synchroniser lesdites vibrations en réaction auxdites données.

9. Un procédé permettant de faire léviter un objet (12), consistant à :

placer l'objet (12) sur une surface (112) de système de lévitation (110) de façon à faire léviter l'objet (12) au-dessus de ladite surface (112) ;
accélérer horizontalement ladite surface (112) ; et
simultanément à ladite accélération horizontale, incliner ladite surface (112) à un angle qui est égal à un angle d'inclinaison d'une somme vectorielle d'une accélération gravitationnelle et de ladite accélération horizontale.

**FIG. 1**

**FIG. 2**

FIG. 3A

FIG. 3B

FIG. 3C

40

50

56

12

54

60

52

52

z

y

x

34

FIG. 4A

40

50

60

56

54

12

52

34

52

z

y

x

FIG. 4B

FIG. 5A

FIG. 5B

FIG. 6A

FIG. 6B

FIG. 7A

FIG. 7B

FIG. 8

FIG. 9A

FIG. 9B

FIG. 10A

FIG. 10B

FIG. 11A

FIG. 11B

## FIG. 12A

## FIG. 12B

unreduced amplitude

reduced amplitude

## FIG. 12C

reduced amplitude

unreduced amplitude

FIG. 13

FIG. 14

FIG. 15A

FIG. 15B

FIG. 16A

FIG. 16B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 3882732 A
- US 4520656 A
- US 4054181 A
- US 4284403 A
- US 4777823 A
- US 5036944 A
- US 5810155 A
- US 6575669 B

### Non-patent literature cited in the description

- **A. MINIKES et al.** Coupled dynamics of a squeeze-film levitated mass and a vibrating piezoelectric disc: numerical analysis and experimental study. *Journal of Sound and Vibration,* 01 May 2003, vol. 263 (2), 241-268